# EUROPEAN PATENT APPLICATION

(11) **EP 1 997 626 A1**
(43) Date of publication of application: **03.12.2008**
(21) Application number: 07425336.0
(22) Date of filing: 01.06.2007
(51) Int. Cl.: B41C 1/10, G03F 7/20

(54) **Image forming apparatus with interchangeable drum, in particular for printing litographic plates**

(71) Applicant: Andromeda S.r.l., 81020 S. Marco Evangelista (CE) (IT)
(72) Inventor: Pignatiello, Felice, 80048 S. Anastasia (NA) (IT); Spano, Paolo, 00139 Roma (IT); De Giacomo, Luigi, 82026 Morcone (BN) (IT)
(74) Representative: Leone, Mario

(57) **Abstract**

An image forming apparatus (1) with interchangeable drum, in particular in the field of the printing of plates suitable to be used in lithography processes, allows the use of different drums in the same apparatus, with an easy replacement operation, and comprises a supporting structure defining a feeding plane for the plates to be exposed; a cylindrical drum (2), apt to receive plates on the outer surface thereof; a frame member (11), supporting said cylindrical drum (2) and said fixing means (106); and a supporting structure (113), apt to receive said frame member so as to correctly position the cylindrical drum (2) and the respective fixing means (106) with respect to said feeding plane.

## Description

The present invention is related to an image forming apparatus with interchangeable drum, in particular in the field of the printing of plates suitable to be used in lithography processes, wherein the image printed in the plate is transferred and reproduced on other media, using the plate as master.

In known apparatuses, the plate is arranged on the outer surface of a rotating cylindrical drum, and one or more exposure heads are used to expose the moving plate by optical means like a laser beam operating in the infrared field, in the ultraviolet field, in the violet light field and in other wavelength fields which can be considered suitable for this task.

The plates are coated with a layer in a technopolymer photosensitive to the light beam projected onto the surface of the plate itself, in this way achieving the image reproduction.

The exposure head is associated to driving means apt to move the head according to a direction parallel to the drum axis, so as to cover the whole surface of the plate while it is rotated.

The group composed by the drum and, in a possible embodiment, by the exposure head, is incorporated within the complex structure of the apparatus.

The latter can be manually fed, through a predefined feeding plane, or can be coupled to a structure receiving means for feeding the plate to be printed, and a storage for the printed plates as well.

The feeding of the plates occurs along a fixed plane, the drum having a predetermined position with respect of such plane.

When the drum assembly requires an ordinary or extraordinary maintenance, the apparatus stops to work until the restoring of the assembly itself. Further, if it is necessary a particular working requiring a special drum, e.g. of different size with respect of that installed, a change of apparatus is requested because the dismantling and remounting operations of the drum are too complex to be carried out in ordinary conditions.

Thus, the known system does not have the flexibility required to use different drums, inside the same apparatus, and this fact forces the user to be provided with a certain number of apparatuses, with all the drawbacks due to the cost and to the room requested.

The technical problem underlying the present invention is to provide an image forming apparatus allowing to obviate to the drawbacks mentioned with reference to the prior art.

Such a problem is solved by an apparatus as above specified wherein a feeding plane is defined for the plates to be exposed and comprising:
* a cylindrical drum, apt to receive photosensitive plates on the outer surface thereof through said feeding plane, with fixing means for said plates;
* a frame member, supporting said cylindrical drum and said fixing means;
* a supporting structure, apt to receive said frame member so as to correctly position the cylindrical drum and the respective fixing means with respect to said feeding plane.

The main advantage of the apparatus according to the present invention lies in allowing the use of different drums in the same apparatus, with an easy replacement operation, wherein the drum is anyway correctly positioned with respect to the plate feeding plane.

In a preferred but non-limitative embodiment, said frame member also supports an exposure head and the related driving means.

The present invention will be hereinafter disclosed according to a preferred embodiment thereof, provided to an exemplificative and non-limitative purpose, with reference to the annexed drawings wherein:

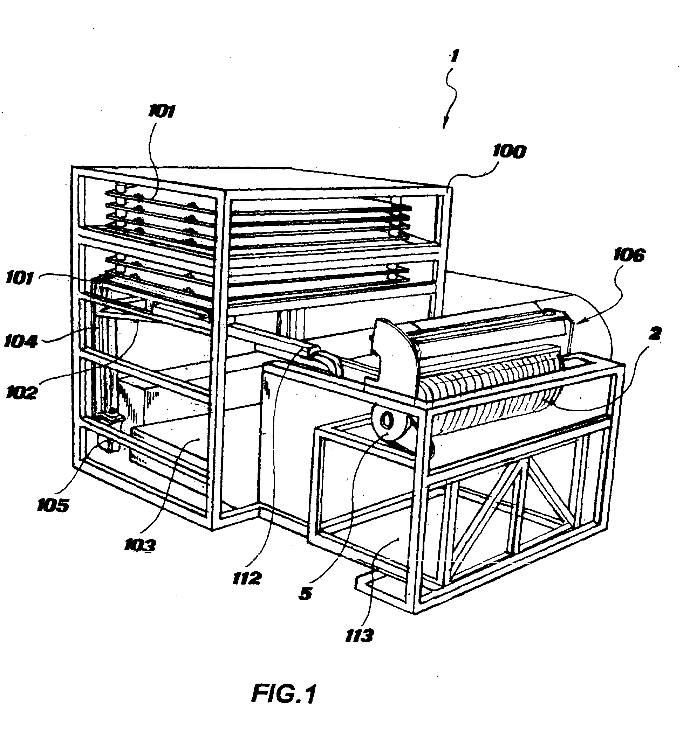

* Figure 1 shows a schematic perspective view of an image forming apparatus according to the invention, with an automatic feeding structure of photosensitive plates;

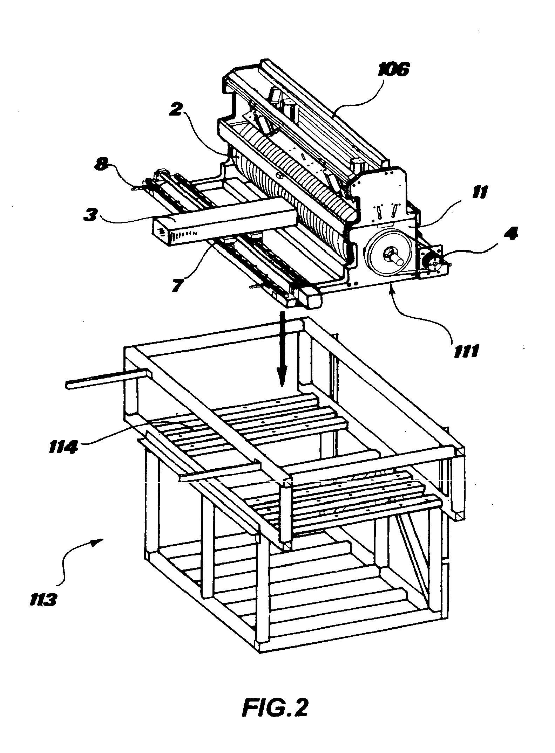

* Figure 2 shows an enlarged perspective view of the apparatus of Figure 1; and

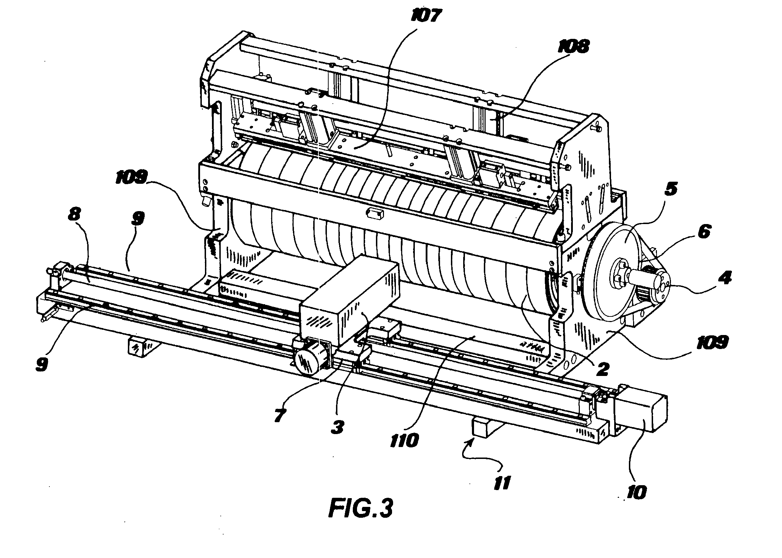

* Figure 3 shows a perspective view in greater detail of the apparatus of Figure 1.

With reference to the Figures, an image forming apparatus is indicated as 1. It is coupled to a supporting structure 100 housing means for feeding and storing photosensitive plates which are stored on suitable trays 101, vertically stacked on the top of a first section. The trays 101 are vertically handled by appropriate lifting means, comprising horizontal supporting arms 102, vertically movable and cantilever-like mounted with respect to vertical guides 104 containing lifting mechanisms driven by suitable lifting motors 105.

Below the stacking of the trays 101, the first section shows a storage 103 of printed photosensitive plates, which are worked in the apparatus of the embodiment herein disclosed.

It comprises a frame member 11, supporting said cylindrical drum 2, apt to receive photosensitive plates on the outer surface thereof. It comprises means for fixing said plates, generally indicated as 106.

In the present embodiment, such fixing means comprises magnetic strips 107 which are deposed on the cylinder 2, longitudinally placed, at the edges of the plate. The fixing means further comprises a positioning and catching system 108 of said strips 107, synchronized with the feeding of the plates. However, it is intended that such fixing means can possibly be operated in cooperation with a vacuum system for forming a pneumatic suction in the gap between the plate and the drum surface. Alternatively or additionally, said means can comprise a mechanical fixing system, with screw-driven brackets. In any case, the definition if the present invention does not depend upon the typology of the used fixing means.

Said frame member 11 supports not only the cylindrical drum 2 but also, in the present embodiment, the devices substantially carrying out the printing of the plate and the handling of the drum 2, starting from an exposure head 3 laterally placed with respect to the drum 2 and mobile along a direction parallel to the axis of the drum 2.

Thus, means for rotating the drum 2 are supported on the frame member 11, at a predetermined rotation rate depending upon the kind of plate and upon the corresponding kind of exposure head 3. A leading sheave wheel 4, connected to non-shown motor means, and a driven sheave wheel 5, integral to the drum 2, represent such means for rotating. The two sheave wheels 4, 5 are joined by a suitable belt 6.

The exposure head 3 is associated to driving means for moving said exposure head 3, being wholly supported by said frame member, according a direction parallel to the axis of the cylindrical drum 2.

Such driving means comprises a respective support system 7 for the exposure head 3. Such system is translated by an endless screw shaft 8 rotated by a motor 10 placed at one end of the lead screw shaft 8. The driving means also comprises straight guides 9 parallel to the axis of the drum 2.

The frame member 11 assures that the mutual distance between the exposure head 3 and the cylindrical drum 2 is constant. The frame member 11 is substantially formed in one piece and comprises a pair of end flat member 109, the drum 2 extending between them, and stringers 110 keeping them together. Such members generally result in a lower resting surface, indicated as 111.

In connection with the drum 2, a feeding plane is identified substantially horizontal, extending so as to be tangential to the drum 2 on its upper side, between the latter and said first section of the supporting structure 100.

Such feeding plane is formed by suitable frame members, arranged above the area wherein the exposure head 3 travels, and constitute the working plane of means for handling the plates, generally indicated as 112.

It is intended that the position of the feeding plane is exclusively due to the drum and set aside the presence of the above described plate feeding system. It can be replaced by any other system or by a manual feeding system, with one or two skilled operators.

The drum assembly is inserted in a supporting structure 14, apt to receive said frame member 11.

The supporting structure 113 is substantially cage-shaped by rod-shaped frame elements, so as to form a resting surface 114 for said frame member 11, and in particular for the lower resting surface 111 thereof.

The position of said resting surface 114 and the shape of the frame member 11 cooperate to correctly position the cylindrical drum 2 and the respective fixing means 106 with respect to said feeding plane.

Furthermore, the resting surface 114 of the supporting structure is open in its upper side, to ease the positioning and the drawing of the whole assembly supported by the frame member 11: the assembly comprising the drum 2 and the rotating means thereof, the fixing means 106 of the plates, the exposure head and the respective driving means.

These components can be easily coupled by quick fasten and release plugs to a control unit, not shown, managing them together with the plate feeding, the punching of the latter and the handling of the trays 101.

In this way, to replace said assembly, it is sufficient to unplug said quick plugs and the electric supply, lift the frame member 11 together with the assembly of components supported thereby and to replace it with another assembly previously stored.

This operation can be easily carried out even by non-experienced personnel, because the adjustments of the distance among the various omponents already took place at the manufacture facility.

In this way, a printing facility can avoid undesired stops of a exposure apparatus, simply carrying out the above described replacement operation.

Then, passing from a manual plate feeding to an automatic feeding or vice-versa, the feeding plane will result as predefined, setting aside the kind of the drum installed in that particular moment.

To the above disclosed image forming apparatus with interchangeable drum a man skilled in the art, to achieve further and contingent needing, can carry out additional changes and variants, all anyway embraced within the protection scope of the present invention, as defined by the annexed claims.

## Claims

1. Image forming apparatus (1) with interchangeable drum, in particular in the field of the printing of plates suitable to be used in lithography processes, wherein a feeding plane is defined for the plates to be exposed and comprising:
* a cylindrical drum (2), apt to receive photosensitive plates on the outer surface thereof through said feeding plane, with fixing means (106) for said plates;
* a frame member (11), supporting said cylindrical drum (2) and said fixing means (106);
* a supporting structure (113), apt to receive said frame member so as to correctly position the cylindrical drum (2) and the respective fixing means (106) with respect to said feeding plane.

2. Apparatus (1) according to claim 1, wherein the frame member (11) supports means for rotating the cylindrical drum (2) at a predetermined rotation rate.

3. Apparatus (1) according to any of the preceding claims, wherein the frame member (11) supports an exposure head (3) and respective driving means for moving said exposure head (3) along a direction parallel to the axis of the cylindrical drum (2).

4. Apparatus (1) according to any of the preceding claims, wherein the frame element (11) is substantially formed in one piece.

5. Apparatus (1) according to any of the preceding claims, wherein the frame member (11) comprises a pair of end flat members (109), the cylindrical drum (2) extending between them, and stringers (110).

6. Apparatus (1) according to claim 5, wherein the end flat members (109) and the stringers (110) result in a lower resting surface (111).

7. Apparatus (1) according to any of the preceding claims, wherein the supporting structure (113) is substantially cage-shaped, so as to form a resting surface (114) for said frame member (11), the position of said resting surface (114) and the shape of the frame member (11) cooperating to correctly position the cylindrical drum (2) with respect to said feeding plane.

8. Apparatus (1) according to claim 7, wherein the resting surface (114) of the supporting structure (113) is open in its upper side.
